# EUROPÄISCHE PATENTANMELDUNG

(11) **EP 0 639 043 A1**
(43) Veröffentlichungstag der Anmeldung: **15.02.1995**
(21) Anmeldenummer: 94112284.8
(22) Anmeldetag: 05.08.1994
(51) Int. Cl.: H05K 3/42

(54) **Verfahren zur Herstellung von durchkontaktierten Leiterplatten mit sehr kleinen Lötaugen**

(30) Priorität: 10.08.1993 DE 4326818
(71) Anmelder: Siemens Nixdorf Informationssysteme AG, D-33106 Paderborn (DE)
(72) Erfinder: Merkenschlager, Hans-Hermann, D-86179 Augsburg (DE); Bischof, Heinz, D-86156 Augsburg (DE); Poloczek, Andreas, D-86156 Augsburg (DE)
(74) Vertreter: Fuchs, Franz-Josef, Dr.-Ing.

(57) **Zusammenfassung**

Die Erfindung bezieht sich auf ein Verfahren zur Herstellung von durchkontaktierten Leiterplatten mit sehr kleinen bzw. keinen Lötaugen.

Durch die wachsende Verdrahtungsdichte werden die Leiterbildstrukturen auf der Plattenoberfläche immer feiner. Der Verkleinerung der Lötaugen an den durchkontaktierten Bohrungen sind insbesondere beim kostengünstigen Ätz-Tentingverfahren enge Grenzen gesetzt. Die Beibehaltung der Fotofolienabdeckung erfordert daher eine Einengung der Fertigungstoleranzen in allen relevanten Prozeßschritten mit der Folge erhöhter Fertigungskosten. Zur Vermeidung der Fertigungskosten und zur weiteren Verdichtung der Leiterbildstrukturen sieht die Erfindung ein Verfahren vor, bei dem die Leiterplatten (1) nach dem chemischen und galvanischen Kupferaufbau (2) beidseitig mit ätzfestem Fotolack (3) beschichtet werden. Nach dem Trockenen den Fotolackes (3) der Leiterplatten (1) werden sie in eine Lösung getaucht, durch die auf den vom Fotolack weitgehend freigebliebenen Wandungen der Durchkontaktierungen (4) eine ätzbeständige Schicht (5) abgeschieden wird. Nach der weiteren üblichen Behandlung der Leiterplatte wird dann die ätzfeste Schicht (5) in den Durchkontaktierungen (4) mittels entsprechender Stripplösungen entfernt.

## Beschreibung

Die Erfindung betrifft ein Verfahren zur Herstellung von durchkontaktierten Leiterplatten mit sehr Kleinen bzw. keinen Lötaugen.

Wegen der Anforderung bezüglich wachsender Verdrahtungsdichte werden die Leiterbildstrukturen auf der Plattenoberfläche von Leiterplatten immer feiner. Der Verkleinerung der Lötaugen an den Durchkontaktierungen sind insbesondere im kostengünstigen Ätz-Tentingverfahren enge Grenzen gesetzt, da die Bohrung mindestens ca. 50 µ von der Fotofolie überdeckt sein muß, sonst ist mit Beschädigung der Ätzabdeckung und damit Ausätzung des Kupfers an den Wandungen der Durchkontaktierungen zu rechnen. Die Beibehaltung der Fotofolienabdeckung erfordert daher eine Einengung der Fertigungstoleranzen in allen relevanten Prozeßschritten wie z.B. Bohren und Leiterbildstrukturierung, mit der Folge erhöhter Fertigungskosten. Eine weitere Möglichkeit besteht u.a. im Einsatz elektrophoretisch abgeschiedener Fotolacke, die die gesamte Leiterplattenoberfläche und die Lochwände schützen. Diese Technologie ist jedoch mit hohen Kosten verbunden und bei kleinen Bohrdurchmessern auf positiv arbeitende Fotolacke mit gegenüber Negativresisten verminderter Lichtempfindlichkeit beschränkt.

Aufgabe der vorliegenden Erfindung ist es, ein technisch einfaches Verfahren zur Herstellung von durchkontaktierten Leiterplatten mit sehr kleinen bzw. keinen Lötaugen anzugeben.

Zur Lösung dieser Aufgabe wird gemaß der Erfindung derart verfahren, daß die Leiterplattennutzen bzw. die Leiterplatten nach dem chemischen und galvanischen Kupferaufbau beidseitig mit ätzfestem Fotolack beschichtet werden, daß nach dem Trocknen des Fotolacks die Leiterplattennutzen bzw. die Leiterplatten in eine Lösung getaucht werden, durch die auf den vom Fotolack weitgehend frei gebliebenen Wandungen der Durchkontaktierungen eine ätzbeständige Schicht abgeschieden wird, daß anschließend die Leiterplattennutzen bzw. Leiterplatten belichtet entwickelt und geätzt werden und daß dann die ätzbeständige Schicht in den Durchkontaktierungen mittels entsprechender Stripplösungen entfernt wird.

Aus Kosten- und Produktivitätsgründen wird vorteilhafterweise negativ arbeitender Lack verwendet.

Zur Erzeugung der ätzbeständigen Schicht in den Durchkontaktierungen kann man Lösungen auf der Basis Imidazol, chemisches Zinn oder andere galvanische Schutzschichten erzeugende Mittel verwenden.

Durch diese Maßnahmen wird erreicht, daß die Kupferoberfläche der Bohrungen unabhängig vom Lackauftrag auf der Oberfläche der Leiterplatten gegen den Ätzangriff geschützt ist. Daher spielt die paßgenaue Lötaugenabdeckung für diesen Prozeßschritt des Verfahrens keine entscheidende Rolle mehr. Die Lötaugen können deshalb wesentlich kleiner gehalten werden bzw. ganz entfallen, wodurch die Leiterbildstrukturen auf der Plattenoberfläche verfeinert werden können.

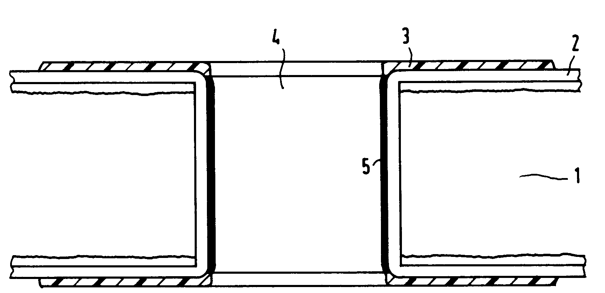

Anhand der Skizze nach der Figur 1 wird das Verfahren näher erläutert.

Dabei zeigt die Figur einen Ausschnitt aus einer Leiterplatte 1. Die Leiterplatte 1 bzw. der Leiterplattennutzen wird nach dem chemischen und galvanischen Kupferaufbau beidseitig mit ätzfestem Fotolack beschichtet. Dabei bleiben die Lochwände zum überwiegenden Teil frei von Lackbeschichtung. Nach dem Trocknen des Lackes wird die Leiterplatte in eine Lösung getaucht, aus der sich auf dem Kupfer der lackfreien Wände der Durchkontaktierungen 4 eine ätzbeständige Schicht 5 abscheidet. Vorzugsweise verwendet man hierzu Lösungen auf der Basis Imidazol bzw. chemisches Zinn oder andere galvanische Schutzschichten erzeugende Mittel. Die Weiterverarbeitung der Leiterplatte 1 bzw. der Nutzen wie z.B. Fotodruck, Entwicklung und alkalisches Ätzen erfolgt wie beim Einsatz von z.B. negativem Resist üblich. Die die Wände der Durchkontaktierungen 4 beim Ätzen schützende Schicht 5 wird nach dem Ätzen mit einer entsprechenden Stripplösung entfernt.

## Patentansprüche

1. Verfahren zur Herstellung von durchkontaktierten Leiterplatten mit sehr kleinen bzw. keinen Lötaugen,
**dadurch gekennzeichnet,**
daß die Leiterplattennutzen bzw. die Leiterplatten nach dem chemischen und galvanischen Kupferaufbau beidseitig mit ätzfestem Fotolack beschichtet werden, daß nach dem Trocknen des Fotolacks die Leiterplattennutzen bzw. die Leiterplatten in eine Lösung getaucht werden, durch die auf den vom Fotolack weitgehend frei gebliebenen Wandungen der Durchkontaktierungen eine ätzbeständige Schicht abgeschieden wird, daß anschließend die Leiterplattennutzen bzw. Leiterplatten belichtet entwickelt und geätzt werden und daß dann die ätzbeständige Schicht in den Durchkontaktierungen erforderlichenfalls mittels entsprechender Stripplösungen entfernt wird.

2. Verfahren nach Anspruch 1,
**dadurch gekennzeichnet,**
daß als Fotoresist negativ arbeitender Fotolack verwendet wird.

3. Verfahren nach einem der vorhergehenden Ansprüche,
**dadurch gekennzeichnet,**
daß die Lösung zur Erzeugung einer ätzbeständigen Schicht auf der Basis von Imidazol, chemischem Zinn oder anderen galvanischen schutzschichterzeugenden Mitteln besteht.
